# EUROPEAN PATENT SPECIFICATION

(11) **EP 4 455 695 B1**
(45) Date of publication and mention of the grant of the patent: **23.09.2026**
(21) Application number: 22909847.0
(22) Date of filing: 14.12.2022
(51) Int. Cl.: G01R 31/3842, G01R 31/3828, G01R 31/396, G01R 31/3835

(54) **METHOD FOR CORRECTING SOC OF BATTERY, AND RELATED APPARATUS**
VERFAHREN ZUR KORREKTUR DES LADESTATUS EINER BATTERIE UND ZUGEHÖRIGE VORRICHTUNG
PROCÉDÉ DE CORRECTION DE L'ÉTAT DE CHARGE D'UNE BATTERIE ET APPAREIL ASSOCIÉ

(30) Priority: 24.12.2021 CN 202111604024
(43) Date of publication of application: 30.10.2024
(73) Proprietor: Great Wall Motor Company Limited, Baoding, Hebei 071000 (CN)
(72) Inventor: WANG, Yin, Baoding, Hebei 071000 (CN); KANG, Wenrong, Baoding, Hebei 071000 (CN); HE, Jiaxin, Baoding, Hebei 071000 (CN); XU, Guangjie, Baoding, Hebei 071000 (CN); ZHANG, Junwei, Baoding, Hebei 071000 (CN)
(74) Representative: Klunker IP Patentanwälte PartG mbB
(86) International application number: PCT/CN2022/139035
(87) International publication number: WO 2023/116533

(56) References cited:
- WO-A1-2020/143193
- WO-A1-2021/220350
- CN-A- 105 742 741
- CN-A- 106 526 495
- CN-A- 107 959 070
- CN-A- 109 975 708
- CN-A- 110 888 060
- CN-A- 113 097 582
- CN-A- 115 113 061
- US-A1- 2015 355 285
- LIU DONG, HUANG BIXIONG, WANG YIQUAN, YAN XIAO, WANG YING: "Inflection point Ah-total integration method for real-time integration to correct lithium battery SOC", ENERGY STORAGE SCIENCE AND TECHNOLOGY, CN, vol. 8, no. 5, 1 September 2019 (2019-09-01), CN , pages 850 - 855, XP093073359, ISSN: 2095-4239, DOI: 10.12028/j.issn.2095-4239.2019.0067
- WANG JIAYUAN, SUN ZECHANG, WEI XUEZHE, DAI HAIFENG: "An Adaptive Method for Automotive Traction Battery Pack SOC Estimation Based on In-pack Cell Uniformity Condition", JOURNAL OF TONGJI UNIVERSITY(NATURAL SCIENCE)., vol. 40, no. 5, 1 May 2020 (2020-05-01), pages 711 - 716, XP093073363

## Description

### TECHNICAL FIELD

The present invention relates to the technical field of battery management and, more particularly, to a method for correcting an SOC of a battery and, related apparatus.

### BACKGROUND

A state of charge (SOC) of a battery system and various levels of components thereof refers to a ratio of a remaining battery capacity to a rated electric capacity. The SOC is a key indicator for determining whether the battery system can operate safely and reliably, and whether the battery system can be managed and controlled accurately. Accurately estimating the SOC of the battery is one of the most important functions of a battery management system (BMS).

However, due to the high degree of nonlinearity in the actual use of the battery, it is usually necessary to correct an estimated SOC value in real time through an optimization algorithm to ensure the accuracy of the SOC estimation. Constant current voltage (CCV) correction is one of the most important correction methods.

The CCV curve can represent a corresponding relationship between the SOC of the battery and a voltage. In the existing CCV correction method, an SOC value of the CCV curve corresponding to the voltage is used as a target corrected value. When the SOC is corrected by the CCV correction method in the conventional technology, a minimum cell voltage changes slowly due to the battery polarity, and the SOC obtained by looking up a CCV curve by using the minimum cell voltage does not correspond to an SOC value obtained by the actual integration of a charging current, which leads to the problem of false correction.

CN 113 097 582 A discloses a method and device for estimating the state of health (SOH) value of a single battery, the method comprising: obtaining the SOC calibration value of each single battery after multiplexing the open-circuit voltage calibration function of a battery system, and correcting a charging curve obtained in the charging process of the battery system through the full-charge calibration value of the highest SOC of the single battery before full-charge current reduction, so that according to the corrected charging curve and the voltage of each single battery before full charge and current reduction, the SOC estimated value of each single battery before full charge and current reduction is accurately calculated; and the SOH value of each single battery is accurately calculated based on the accumulated charging electric quantity and the accumulated discharging electric quantity of the battery during open-circuit voltage calibration and before full-charge current reduction, the SOC calibration value and the SOC estimated value of each single battery.

CN 106 526 495 A discloses a battery pack SOC evaluation method and a battery pack SOC evaluation system, which are applied to electric car for estimating SOC of a battery pack. The battery pack comprises a plurality of battery cells. The battery pack SOC evaluation method includes the steps of real-time acquiring the voltage and total current of the battery cells, comparing the voltages of the plurality of battery cells to obtain the battery cell with the highest voltage and the battery cell with the lowest voltage, determining whether the battery pack is under a constant current charging state, estimating the capacity of the battery cell with the highest voltage and the capacity of the battery cell with the lowest voltage, if the battery pack is under a constant current charging state, estimating the SOC of the battery cell with the highest voltage and the SOC of the battery cell with the lowest voltage, and estimating the SOC of the battery pack.

### SUMMARY

### Technical problem

In view of this, it is an object of the present invention to provide a method for correcting an SOC of a battery and a related apparatus, which may solve the problem of low accuracy of the prior art in estimating the SOC of the battery.

### Technical solution

The object is achieved with the features of the independent claim 1 regarding the method, with the features of the independent claim 5 regarding the apparatus as well as with the features of claim 6 and 7 regarding processor-based/computer program-based implementations thereof.

### Beneficial effects

Compared with the conventional technology, the method for correcting the SOC of the battery provided by the present invention has the beneficial effects:
the method provided by the present invention is used for correcting the SOC of the battery through the following steps: acquiring a measured voltage of each battery cell in sequence; determining a maximum voltage value and a first battery cell corresponding to the maximum voltage value as well as a minimum voltage value and a second battery cell corresponding to the minimum voltage value according to the measured voltage of each battery cell; determining a target SOC value according to the maximum voltage value and a preset CCV curve; and correcting a calculated SOC value of the second battery cell according to the target SOC value and a calculated SOC value of the first battery cell to obtain a corrected SOC value of the second battery cell. In the process of correcting the SOC of the battery through the above steps, a voltage difference between a maximum voltage cell and a minimum voltage cell is considered when an SOC of the minimum voltage cell is corrected. Since the voltage value of the battery cell with the minimum voltage changes slow, using the voltage value of the battery cell with the minimum voltage may lead to false correction. In the present application, by using the method above, the problem of false correction caused by using a voltage value of a battery cell with a minimum voltage to look up the CCV curve and obtain the corrected SOC value can be avoided.

### BRIEF DESCRIPTION OF THE DRAWINGS

In order to more clearly illustrate the technical solutions of the present invention, the figures that are required to describe the invention or the prior art will be briefly described below.
FIG. 1 is an implementation flowchart of a method for correcting an SOC of a battery;
FIG. 2 is a schematic diagram of the structural composition of an apparatus for correcting an SOC of a battery; and
FIG. 3 is a schematic diagram of the structural composition of a controlling apparatus.

### DETAILED DESCRIPTION OF THE EMBODIMENTS

In the following description, specific details such as specific system structures and technologies are provided for illustrating purposes rather than limitation, to facilitate a thorough understanding of the present invention.

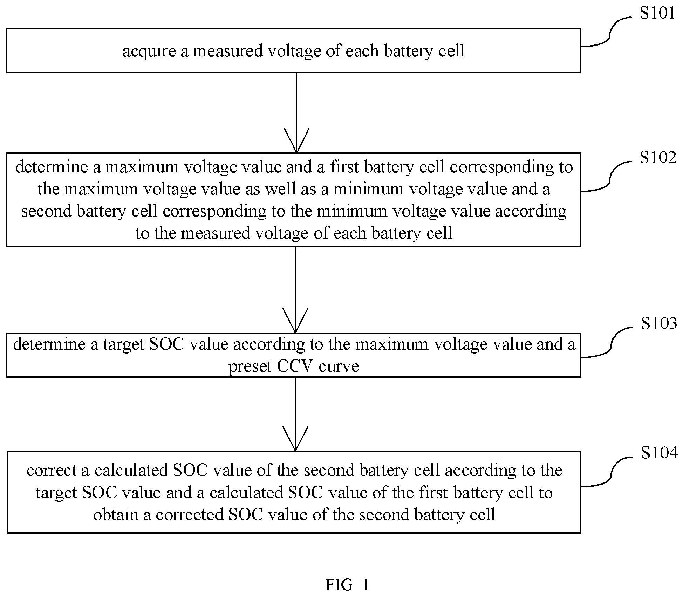

Referring to FIG. 1, an implementation flowchart of a method for correcting an SOC of a battery is shown. The method shown in FIG. 1 is applied to a battery including a plurality of battery cells and consists of four steps, S101 to S104, each of which is described in detail below.

In S101, acquiring a measured voltage of each battery cell.

In this step, the measured voltage of each battery cell may be acquired in real time through a voltage sensor.

In S102, according to the measured voltage of each battery cell, determining a maximum voltage value and a first battery cell corresponding to the maximum voltage value, as well as a minimum voltage value and a second battery cell corresponding to the minimum voltage value.

In this step, the maximum voltage value *U*ₘₐₓ is determined according to the measured voltage of each battery cell, and the battery cell corresponding to the maximum voltage value is determined to be a first battery cell. In addition, the minimum voltage value *U*ₘᵢₙ is determined, and the battery cell corresponding to the minimum voltage value is determined to be a second battery cell.

In S103, determining a target SOC value according to the maximum voltage value and a preset constant current voltage (CCV) curve.

The CCV curve can represent a corresponding relationship between the SOC of the battery and a voltage.

In this step, the SOC value corresponding to the maximum voltage value *U*ₘₐₓ is obtained by looking up the CCV curve, and the value is the target SOC value *SOC*_{target}.

In S104, correcting a calculated SOC value of the second battery cell according to the target SOC value and a calculated SOC value of the first battery cell to obtain a corrected SOC value of the second battery cell.

When the SOC is corrected by using the CCV correction method in the prior art, the following two methods are often adopted.
(1) looking up a CCV curve according to a maximum value and a minimum value of a measured voltage to obtain corresponding maximum and minimum SOC values respectively; correcting a currently calculated SOC maximum value by using the obtained maximum SOC value; and correcting a currently calculated SOC minimum value by using the obtained minimum SOC value.
   The method has the following disadvantage: due to the polarity of the battery, the minimum cell voltage changes slowly. Therefore, in the method (1), an SOC obtained by looking up the CCV curve using the minimum cell voltage does not correspond to an SOC value obtained by the actual integration of a charging current, and the problem of false correction will be caused if the value is used to correct the minimum SOC.
(2) correcting the currently calculated maximum and minimum SOC values at the same time according to the maximum value of the measured voltage.
   obtaining an SOC value by looking up the CCV curve according to the maximum value of the measured voltage, and the value is used to correct the currently calculated maximum and minimum SOC values at the same time.

The method has the following disadvantage: in the method (2), a target SOC value is obtained by simply looking up the CCV curve according to the maximum value of the measured voltage, and if the currently calculated minimum SOC value is forcibly increased according to the SOC value, the SOC correction will lose a differential pressure characteristic, resulting in false correction. If the characteristics of respective cell cores are inconsistent in the later stage, forcibly increasing the SOC value of the core with low voltage will lead to an over-discharge problem.

In the four steps shown in FIG. 1, a difference between the SOC value (i.e., the target SOC value) obtained by looking up a table and the calculated SOC value may be determined according to a target SOC value and a calculated SOC value of the maximum voltage cell. Further, the calculated SOC value of the minimum voltage cell can be corrected based on the difference. The method, on the one hand, avoids the problem of an inaccurate SOC value caused by looking up the CCV curve due to a minimum voltage cell and slow voltage conversion, and on the other hand, also avoids the problem of losing a differential voltage characteristic caused by directly looking up the CCV curve by the maximum voltage cell and obtaining the target SOC value to correct the calculated SOC value of the minimum voltage cell.

In an alternative example not forming part of the claimed subject-matter, a difference between the calculated SOC value of the first battery cell and the calculated SOC value of the second battery cell is calculated, and the corrected SOC value of the second battery cell is obtained by subtracting the difference from the target SOC value.

In the claimed subject-matter, the difference between the target SOC value and the calculated SOC value of the first battery cell is acquired; and the corrected SOC value of the second battery cell is obtained by adding the calculated SOC value of the second battery cell with the difference.

The target SOC value is taken as the corrected SOC value of the first battery cell.

The calculated SOC value of the first battery cell and the calculated SOC value of the second battery cell are acquired through an ampere-hour integration method.

As a highly complex nonlinear system, an SOC of a lithium-ion battery cannot be directly measured, but can only be estimated by parameters such as a battery terminal voltage, a charging/discharging current, and an internal resistance.

The calculated SOC value of each battery cell is acquired through the ampere-hour integration method. Before the ampere-hour integration method is used, an initial SOC value of the battery cell needs to be obtained. The ampere-hour integration method may be used to calculate a cumulative charge ampere-hour or a cumulative discharge ampere-hour obtained by the integration of current and time of the battery cell within a period of time, and combined with the above-mentioned initial SOC value, the calculated SOC value of the battery at the current moment can be obtained by using the ampere-hour integration method. Therefore, for any battery cell, when the calculated SOC value of the battery cell is obtained by the ampere-hour integration method, an accurate calculated SOC value of the battery cell can be obtained only when the initial SOC value of the battery cell is accurate and the integration process of the battery cell is accurate.

In other words, the calculation accuracy of the ampere-hour integration method depends on the accuracy of the initial SOC value of the battery cell. The accurate calculated SOC value can be obtained just by ensuring an accurate initial SOC value. If there is a deviation in the initial SOC value, an error of the calculated SOC value will accumulate and become larger, resulting in low accuracy of the calculated SOC value.

In order to obtain the accurate initial SOC value of the battery cell, the method provided above further includes the following steps: determining whether a standing duration of the battery before the start of the present charge and discharge has reached a preset duration; if it is determined that the standing duration of the battery before the start of the present charge and discharge is larger than or equal to the preset duration, acquiring an open circuit voltage of the battery cell for each battery cell, and determining an initial SOC value of the battery cell according to the open circuit voltage of the battery cell; and if it is determined that the standing duration of the battery before the start of the present charge and discharge is less than the preset duration, reading an SOC value of the battery cell in a preset storage space when the battery is powered off last time, the SOC value being used as the initial SOC value of the battery cell.

The standing duration refers to a duration of a battery pack system corresponding to the battery from a last power-off and shutdown moment to the present start-up moment.

The open circuit voltage (OCV) refers to a static open circuit voltage of a core. Polarization will occur to the core after charging or discharging. At this time, an external characteristic voltage of the core is inconsistent with the static open circuit voltage of the cell, so it is necessary to let the core stand for a certain period of time to eliminate polarization. A voltage after standing is the static open circuit voltage (i.e., OCV). The battery has an ohmic resistance and a polarization resistance inside, and leads to hysteresis caused by electrochemical polarization and concentration polarization, so a stable terminal voltage needs to be obtained by standing and evenly distributing electrolyte inside the battery.

If it is determined that the standing duration of the battery before the start of the present charge and discharge has reached the preset duration, the initial SOC value of the battery is obtained by looking up an OCV-SOC table. In this case, the initial SOC value is more accurate.

If it is determined that the standing duration of the battery before the start of the present charge and discharge is less than the preset duration, for each battery cell, the SOC value of the battery cell is read in the preset storage space when the battery is powered off last time, the SOC value being used as the initial SOC value of the battery cell. In this case, the initial SOC value of the battery is obtained by looking up the OCV-SOC table, which has low accuracy and will lead to a large error.

After the initial SOC value of the first battery cell and the initial SOC value of the second battery cell are obtained, a calculated SOC value of the first battery cell and a calculated SOC value of the second battery cell may be calculated through the ampere-hour integration method according to the initial SOC value of the first battery cell and the initial SOC value of the second battery cell. The initial SOC value obtained by the first two steps has high accuracy. Therefore, the calculated SOC value of the first battery cell and the calculated SOC value of the second battery cell, which are calculated here, are both highly accurate.

Calculating the calculated SOC value of the first battery cell and the calculated SOC value of the second battery cell through the ampere-hour integration method according to the initial SOC value of the first battery cell and the initial SOC value of the second battery cell may include:
for each battery cell in the first battery cell and the second battery cell, acquiring a calculated SOC value of the battery cell through a preset formula, the preset formula being as follows:
   $SOC = {SOC}_{0} - \frac{1}{{C}_{N}} {\int }_{0}^{t} Idt ;$
in which: *SOC* is the calculated SOC value of the battery cell; *SOC₀* is an initial SOC value of the battery cell; *C_{N}* is a rated capacity of the battery cell; and *I* is a current of this battery cell. When the battery cell is in a charging process, a value of *I* is negative. When the battery cell is in a discharging process, a value of *I* is positive. An absolute value of ${\int }_{0}^{t} Idt$ represents a cumulative charge ampere-hour of the battery cell from an initial moment of charge to a moment t, or a cumulative discharge ampere-hour of the battery from an initial moment of discharge to the moment t.

As can be seen from the above description, the method provided by the present application can implement the correction of the SOC of the battery through the following steps: acquiring a measured voltage of each battery cell in sequence; determining a maximum voltage value and a first battery cell corresponding to the maximum voltage value as well as a minimum voltage value and a second battery cell corresponding to the minimum voltage value according to the measured voltage of each battery cell; determining a target SOC value according to the maximum voltage value and a preset CCV curve; and correcting a calculated SOC value of the second battery cell according to the target SOC value and a calculated SOC value of the first battery cell to obtain a corrected SOC value of the second battery cell. In the process of correcting the SOC of the battery through the above steps, a voltage difference between a maximum voltage cell and a minimum voltage cell is considered when an SOC of the minimum voltage cell is corrected. Since the voltage value of the battery cell with the minimum voltage changes slow, using the voltage value of the battery cell with the minimum voltage may lead to false correction. In the present application, by using the method above, the problem of false correction caused by using a voltage value of a battery cell with a minimum voltage to look up the CCV curve and obtain the corrected SOC value can be avoided.

It should be understood that the magnitudes of serial numbers of each step does not mean an order of execution, and the order of execution of each process should be determined by its function and internal logic, but shall not constitute any limitation on the implementation process of the present invention.

The following is a device of the present invention. Details not described in detail may refer to the corresponding method described above.

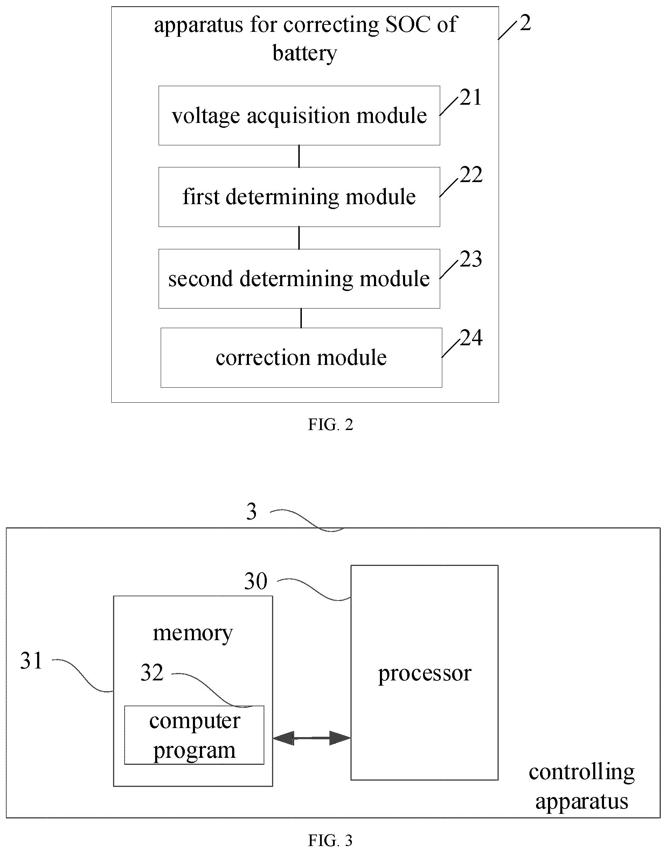

FIG. 2 shows the structural composition of an apparatus for correcting an SOC of a battery provided by the present invention. For ease of description, only the parts related to the present application are shown in FIG. 2, and details are described below.

As shown in FIG. 2, the apparatus 2 for correcting the SOC of the battery includes a voltage acquisition module 21, a first determining module 22, a second determining module 23 and a correction module 24.

The voltage acquisition module 21 is configured to acquire a measured voltage of each battery cell.

The first determining module 22 is configured to determine a maximum voltage value and a first battery cell corresponding to the maximum voltage value, as well as a minimum voltage value and a second battery cell corresponding to the minimum voltage value according to the measured voltage of each battery cell.

The second determining module 23 is configured to determine a target SOC value according to the maximum voltage value and a preset CCV curve.

The correction module 24 is further configured to correct a calculated SOC value of the second battery cell according to a target SOC value and a calculated SOC value of the first battery cell to obtain a corrected SOC value of the second battery cell.

The apparatus 2 provided by the present application is capable of correcting the SOC of the battery by performing the following steps: acquiring a measured voltage of each battery cell in sequence; determining a maximum voltage value and a first battery cell corresponding to the maximum voltage value as well as a minimum voltage value and a second battery cell corresponding to the minimum voltage value according to the measured voltage of each battery cell; determining a target SOC value according to the maximum voltage value and a preset CCV curve; and correcting a calculated SOC value of the second battery cell according to the target SOC value and a calculated SOC value of the first battery cell to obtain a corrected SOC value of the second battery cell. In the process of correcting the SOC of the battery through the above steps, a voltage difference between a maximum voltage cell and a minimum voltage cell is considered when an SOC of the minimum voltage cell is corrected. Since the voltage value of the battery cell with the minimum voltage changes slow, using the voltage value of the battery cell with the minimum voltage may lead to false correction. In the present application, by using the method above, the problem of false correction caused by using a voltage value of a battery cell with a minimum voltage to look up the CCV curve and obtain the corrected SOC value can be avoided.

The correction module 24 is configured to:
acquire a difference between the target SOC value and the calculated SOC value of the first battery cell; and
add the calculated SOC value of the second battery cell with the difference to obtain the corrected SOC value of the second battery cell.

The correction module 24 may be configured to:
take the target SOC value as a corrected SOC value of the first battery cell.

The correction module 24 is configured to:
acquire the calculated SOC value of the first battery cell and the calculated SOC value of the second battery cell through an ampere-hour integration method.

The correction module 24 may be configured to:
determine whether a standing duration of the battery before the start of the present charge and discharge has reached a preset duration;
if it is determined that the standing duration of the battery before the start of the present charge and discharge is larger than or equal to the preset duration, acquire, for each battery cell, an open circuit voltage of the battery cell, and determine an initial SOC value of the battery cell according to the open circuit voltage of the battery cell;
if it is determined that the standing duration of the battery before the start of the present charge and discharge is less than the preset duration, read, for each battery cell, an SOC value of the battery cell in a preset storage space when the battery is powered off last time, the SOC value being used as the initial SOC value of the battery cell; and
calculate a calculated SOC value of the first battery cell and a calculated SOC value of the second battery cell through an ampere-hour integration method according to the initial SOC value of the first battery cell and the initial SOC value of the second battery cell.

The correction module 24 may be configured to:
for each battery cell in the first battery cell and the second battery cell, acquire a calculated SOC value of the battery cell through a preset formula, the preset formula being as follows:
   $SOC = {SOC}_{0} - \frac{1}{{C}_{N}} {\int }_{0}^{t} Idt ;$
in which: *SOC* is the calculated SOC value of the battery cell; *SOC₀* is an initial SOC value of the battery cell; *C_{N}* is a rated capacity of the battery cell; and *I* is a current of the battery cell. When the battery cell is in a charging process, a value of *I* is negative. When the battery cell is in a discharging process, a value of *I* is positive. An absolute value of ${\int }_{0}^{t} Idt$ represents a cumulative charge ampere-hour of the battery cell from an initial moment of charge to a moment t, or a cumulative discharge ampere-hour of the battery from an initial moment of discharge to the moment t.

The apparatus for correcting the SOC of the battery provided above may be configured to perform the method for correcting the SOC of the battery. Their implementation principles and technical effects are similar, and thus are not repeated.

The present invention further provides a vehicle. The vehicle includes a controlling apparatus. FIG. 3 is a schematic diagram of the structural composition of the controlling apparatus provided by the present invention. As shown in FIG. 3, the controlling apparatus 3 includes a processor 30, a memory 31 and a computer program 32 which is stored in the memory 31 and capable of operating on the processor 30. The processor 30 implements the steps (e.g., S101 to S104 shown in FIG. 1) in each of the above methods for correcting the SOC of the battery while executing the computer program 32. Alternatively, the processor 30 implements the functions (e.g., the functions of units 21 to 24 shown in FIG. 2) of various modules/units in the above apparatus while executing the computer program 32.

Exemplarily, the computer program 32 may be divided into one or more modules/units, wherein the one or more modules/units can be stored in the memory 31, and executed by the processor 30 to complete the technical solutions provided by the present invention. These modules/units may be a series of computer program instruction segments capable of completing a particular function, these instruction segments being configured to describe an execution process of the computer program 32 in the controlling apparatus 3.

The controlling apparatus 3 may be a hardware part of a battery management system (BMS) or a part of the hardware part. The controlling apparatus 3 may include, but is not limited to, a processor 30 and a memory 31. Those skilled in the art can understand that FIG. 3 is only an example of the controlling apparatus 3 and does not constitute a limitation of the controlling apparatus 3. The controlling apparatus 3 may include more or less components than those illustrated, or combine some components or adopt different components. For example, the controlling apparatus 3 may also include an input/output device, a network access device, a bus and the like.

The processor 30 may be a central processing unit (CPU), a universal processor, a digital signal processor (DSP), an application specific integrated circuit (ASIC), a field-programmable gate array (FPGA), or other programmable logic devices, discrete gates or transistor logic devices, discrete hardware components, or the like. The universal processor may be a microprocessor, or any conventional processor.

The memory 31 may be an internal storage unit of the controlling apparatus 3, such as a hard disk or memory of the controlling apparatus 3. The memory 31 may also be an external storage device of the controlling apparatus 3, such as a pluggable hard disk, a smart memory card (SMC), a secure digital (SD) card or a flash card equipped on the controlling apparatus 3. Further, the memory 31 may also include both an internal storage unit and an external storage device of the controlling apparatus 3. The memory 31 is configured to store a computer program 32 as well as other programs and data required by the controlling apparatus 3. The memory 31 may also be configured to temporarily store data that has been or will be outputted.

When integrated modules/units are implemented in the form of software functional units and sold or used as independent products, they can be stored in a computer-readable storage medium. Based on the understanding, the present application implements all or part of the processes in the above-mentioned methods, which can be completed by controlling the relevant hardware through the computer programs. The computer program can be stored in a computer-readable storage medium, and when executed by a processor, it can implement the steps of the various acceleration control methods of the vehicle described above. Among them, the computer programs include computer program codes, which can be in the form of source codes, object codes, executable files, or some intermediate forms. The computer-readable medium can include: any entity or device capable of carrying the computer program codes, recording mediums, USB flash drives, portable hard drives, magnetic disks, optical disks, computer memory, read-only memory (ROM), random access memory (RAM), electric carrier signals, telecommunications signals, and software distribution medium. It should be noted that the content contained in the computer-readable medium can be appropriately added or removed according to the requirements of legislation and patent practice within the jurisdiction. For example, in some jurisdictions, according to the legislation and the patent practice, the computer-readable medium do not include the electric carrier signals and the telecommunications signals.

## Claims

1. A method for correcting a state of charge, SOC, of a battery, which is applied to a battery including a plurality of battery cells, the method comprising:
(S101) acquiring a measured voltage of each battery cell;
(S102) determining, according to the measured voltage of each battery cell, a maximum voltage value (Uₘₐₓ) and a first battery cell corresponding to the maximum voltage value and a minimum voltage value (Uₘᵢₙ) and a second battery cell corresponding to the minimum voltage value;
**characterized by**
(S103) determining a target SOC value (SOC_{target}) according to the maximum voltage value (Uₘₐₓ) and a preset constant current voltage, CCV, curve stored as a table by looking up, in the preset CCV curve, the SOC value corresponding to the maximum voltage value (Uₘₐₓ); and
(S104) correcting a calculated SOC value of the second battery cell according to the target SOC (SOC_{target}) value and a calculated SOC value of the first battery cell to obtain a corrected SOC value of the second battery cell, wherein the calculated SOC value of the first battery cell and the calculated SOC value of the second battery cell are acquired through an ampere-hour integration method, by acquiring a difference between the target SOC value and the calculated SOC value of the first battery cell, and adding the calculated SOC value of the second battery cell with the difference to obtain the corrected SOC value of the second battery cell.

2. The method according to claim 1, further comprising:
taking the target SOC value as a corrected SOC value of the first battery cell.

3. The method according to claim 1, wherein the step of acquiring the calculated SOC value of the first battery cell and the calculated SOC value of the second battery cell through the ampere-hour integration method comprises:
determining whether a standing duration of the battery before a start of the present charge and discharge reaches a preset duration;
if it is determined that the standing duration of the battery before the start of the present charge and discharge is larger than or equal to the preset duration, acquiring, for each battery cell, an open circuit voltage of the battery cell, and determining an initial SOC value of the battery cell according to the open circuit voltage of the battery cell;
if it is determined that the standing duration of the battery before the start of the present charge and discharge is less than the preset duration, reading, for each battery cell, an SOC value of the battery cell in a preset storage space when the battery is powered off last time, the SOC value being used as the initial SOC value of the battery cell; and
calculating a calculated SOC value of the first battery cell and a calculated SOC value of the second battery cell through an ampere-hour integration method according to the initial SOC value of the first battery cell and the initial SOC value of the second battery cell.

4. The method according to claim 3, wherein the step of calculating the calculated SOC value of the first battery cell and the calculated SOC value of the second battery cell through the ampere-hour integration method according to the initial SOC value of the first battery cell and the initial SOC value of the second battery cell comprises:
for each battery cell in the first battery cell and each battery cell in the second battery cell, acquiring a calculated SOC value of the battery cell through a preset formula, the preset formula being: $SOC = {SOC}_{0} - \frac{1}{{C}_{N}} {\int }_{0}^{t} Idt ;$
in which: *SOC* is the calculated SOC value of the battery cell; *SOC₀* is an initial SOC value of the battery cell; *C_{N}* is a rated capacity of the battery cell; and *I* is a current of the battery cell; when the battery cell is in a charging process, a value of *I* is negative; when the battery cell is in a discharging process, a value of *I* is positive; an absolute value of ${\int }_{0}^{t} Idt$ represents a cumulative charge ampere-hour of the battery cell from an initial moment of charge to a moment t, or a cumulative discharge ampere-hour of the battery from an initial moment of discharge to the moment t.

5. An apparatus (2) for correcting a state of charge, SOC, of a battery, comprising a voltage acquisition module (21), a first determining module (22), a second determining module (22) and a correction module (24), wherein
the voltage acquisition module (21) is configured to acquire a measured voltage of each battery cell in sequence;
the first determining module (22) is configured to, according to the measured voltage of each battery cell, determine a maximum voltage value (Uₘₐₓ) and a first battery cell corresponding to the maximum voltage value and a minimum voltage value (Uₘᵢₙ) and a second battery cell corresponding to the minimum voltage value;
**characterized in that**
the second determining module (23) is configured to determine a target SOC value (SOC_{target}) according to the maximum voltage value (Uₘₐₓ) and a preset constant current voltage, CCV, curve stored as a table by looking up, in the preset CCV curve, the SOC value corresponding to the maximum voltage value (Uₘₐₓ); and
the correction module (24) is configured to correct a calculated SOC value of the second battery cell according to the target SOC value (SOC_{target}) and a calculated SOC value of the first battery cell to obtain a corrected SOC value of the second battery cell, wherein the calculated SOC value of the first battery cell and the calculated SOC value of the second battery cell are acquired through by an ampere-hour integration method, wherein the correction module (24) is configured to acquire a difference between the target SOC value (SOC_{target}) and the calculated SOC value of the first battery cell, and to add the calculated SOC value of the second battery cell with the difference to obtain the corrected SOC value of the second battery cell.

6. A vehicle, comprising a controlling apparatus (3), wherein the controlling apparatus (3) comprises a memory (31), a processor (30), and a computer program (32) which is stored in the memory (31) and operable on the processor (30), the processor (30) being configured to implement the steps of the method according to any one of claims 1 to 4 when executing the computer program (32).

7. A computer-readable storage medium, having stored a computer program (32) therein, the computer program (32) being executed by a processor (30) to implement the steps of the method according to any one of claims 1 to 4.

## Patentansprüche

1. Verfahren zum Korrigieren eines Ladezustands, SOC, einer Batterie, das auf eine Batterie angewendet wird, die mehrere Batteriezellen aufweist, wobei das Verfahren aufweist:
(S101) Erfassen einer gemessenen Spannung jeder Batteriezelle;
(S102) Bestimmen, anhand der gemessenen Spannung jeder Batteriezelle, eines maximalen Spannungswerts (Uₘₐₓ) und einer ersten Batteriezelle, die dem maximalen Spannungswert entspricht, und eines minimalen Spannungswerts (Uₘᵢₙ) und einer zweiten Batteriezelle, die dem minimalen Spannungswert entspricht;
**gekennzeichnet durch**
(S103) Bestimmen eines Ziel-SOC-Werts (SOC_{target}) anhand des maximalen Spannungswerts (Uₘₐₓ) und einer voreingestellten Konstantstrom-Spannungskurve, CCV, die als Tabelle gespeichert ist, durch Nachschlagen des dem maximalen Spannungswert (Uₘₐₓ) entsprechenden SOC-Werts in der voreingestellten CCV-Kurve; und
(S104) Korrigieren eines berechneten SOC-Werts der zweiten Batteriezelle anhand des Ziel-SOC-Werts (SOC_{target}) und eines berechneten SOC-Werts der ersten Batteriezelle, um einen korrigierten SOC-Wert der zweiten Batteriezelle zu erhalten, wobei der berechnete SOC-Wert der ersten Batteriezelle und der berechnete SOC-Wert der zweiten Batteriezelle durch ein Amperestunden-Integrationsverfahren erfasst werden, indem eine Differenz zwischen dem Ziel-SOC-Wert und dem berechneten SOC-Wert der ersten Batteriezelle erfasst wird und der berechnete SOC-Wert der zweiten Batteriezelle mit der Differenz addiert wird, um den korrigierten SOC-Wert der zweiten Batteriezelle zu erhalten.

2. Verfahren nach Anspruch 1, ferner aufweisend:
Verwenden des Ziel-SOC-Werts als einen korrigierten SOC-Wert der ersten Batteriezelle.

3. Verfahren nach Anspruch 1, wobei der Schritt des Erfassens des berechneten SOC-Werts der ersten Batteriezelle und des berechneten SOC-Werts der zweiten Batteriezelle durch das Amperestunden-Integrationsverfahren aufweist:
Bestimmen, ob eine Standdauer der Batterie vor einem Beginn der vorliegenden Ladung und Entladung eine voreingestellte Dauer erreicht;
wenn bestimmt wird, dass die Standdauer der Batterie vor dem Beginn der vorliegenden Ladung und Entladung größer als oder gleich der voreingestellten Dauer ist, Erfassen, für jede Batteriezelle, einer Leerlaufspannung der Batteriezelle und Bestimmen eines Anfangs-SOC-Werts der Batteriezelle anhand der Leerlaufspannung der Batteriezelle;
wenn bestimmt wird, dass die Standdauer der Batterie vor dem Beginn der vorliegenden Ladung und Entladung kleiner als die voreingestellte Dauer ist, Auslesen, für jede Batteriezelle, eines SOC-Werts der Batteriezelle in einem voreingestellten Speicherbereich, als die Batterie zuletzt ausgeschaltet wurde, wobei der SOC-Wert als der Anfangs-SOC-Wert der Batteriezelle verwendet wird; und
Berechnen eines berechneten SOC-Werts der ersten Batteriezelle und eines berechneten SOC-Werts der zweiten Batteriezelle durch ein Amperestunden-Integrationsverfahren anhand des Anfangs-SOC-Werts der ersten Batteriezelle und des Anfangs-SOC-Werts der zweiten Batteriezelle.

4. Verfahren nach Anspruch 3, wobei der Schritt des Berechnens des berechneten SOC-Werts der ersten Batteriezelle und des berechneten SOC-Werts der zweiten Batteriezelle durch das Amperestunden-Integrationsverfahren anhand des Anfangs-SOC-Werts der ersten Batteriezelle und des Anfangs-SOC-Werts der zweiten Batteriezelle aufweist:
für jede Batteriezelle in der ersten Batteriezelle und jede Batteriezelle in der zweiten Batteriezelle, Erfassen eines berechneten SOC-Werts der Batteriezelle durch eine voreingestellte Formel, wobei die voreingestellte Formel lautet: $SOC = SO {C}_{0} - \frac{1}{{C}_{N}} {\int }_{0}^{t} Idt$
wobei: SOC der berechnete SOC-Wert der Batteriezelle ist; SOC₀ ein Anfangs-SOC-Wert der Batteriezelle ist; C_{N} eine Nennkapazität der Batteriezelle ist; und *I* ein Strom der Batteriezelle ist; wenn sich die Batteriezelle in einem Ladevorgang befindet, ein Wert von *I* negativ ist; wenn sich die Batteriezelle in einem Entladevorgang befindet, ein Wert von *I* positiv ist; ein Absolutwert von ${\int }_{0}^{t} Idt$ eine kumulative Lade-Amperestunde der Batteriezelle von einem Anfangszeitpunkt der Ladung bis zu einem Zeitpunkt t oder eine kumulative Entlade-Amperestunde der Batterie von einem Anfangszeitpunkt der Entladung bis zu dem Zeitpunkt t darstellt.

5. Vorrichtung (2) zum Korrigieren eines Ladezustands, SOC, einer Batterie, aufweisend ein Spannungserfassungsmodul (21), ein erstes Bestimmungsmodul (22), ein zweites Bestimmungsmodul (22) und ein Korrekturmodul (24), wobei
das Spannungserfassungsmodul (21) dazu ausgebildet ist, eine gemessene Spannung jeder Batteriezelle nacheinander zu erfassen;
das erste Bestimmungsmodul (22) dazu ausgebildet ist, anhand der gemessenen Spannung jeder Batteriezelle einen maximalen Spannungswert (Uₘₐₓ) und eine erste Batteriezelle, die dem maximalen Spannungswert entspricht, und einen minimalen Spannungswert (Uₘᵢₙ) und eine zweite Batteriezelle, die dem minimalen Spannungswert entspricht, zu bestimmen;
**dadurch gekennzeichnet, dass**
das zweite Bestimmungsmodul (23) dazu ausgebildet ist, einen Ziel-SOC-Wert (SOCtarget) anhand des maximalen Spannungswerts (Uₘₐₓ) und einer voreingestellten Konstantstrom-Spannungskurve, CCV, die als Tabelle gespeichert ist, durch Nachschlagen des dem maximalen Spannungswert (Uₘₐₓ) entsprechenden SOC-Werts in der voreingestellten CCV-Kurve zu bestimmen; und
das Korrekturmodul (24) dazu ausgebildet ist, einen berechneten SOC-Wert der zweiten Batteriezelle anhand des Ziel-SOC-Werts (SOC_{target}) und eines berechneten SOC-Werts der ersten Batteriezelle zu korrigieren, um einen korrigierten SOC-Wert der zweiten Batteriezelle zu erhalten, wobei der berechnete SOC-Wert der ersten Batteriezelle und der berechnete SOC-Wert der zweiten Batteriezelle durch ein Amperestunden-Integrationsverfahren erfasst werden, wobei das Korrekturmodul (24) dazu ausgebildet ist, eine Differenz zwischen dem Ziel-SOC-Wert (SOC_{target}) und dem berechneten SOC-Wert der ersten Batteriezelle zu erfassen und den berechneten SOC-Wert der zweiten Batteriezelle mit der Differenz zu addieren, um den korrigierten SOC-Wert der zweiten Batteriezelle zu erhalten.

6. Fahrzeug, aufweisend eine Steuervorrichtung (3), wobei die Steuervorrichtung (3) einen Speicher (31), einen Prozessor (30) und ein Computerprogramm (32), das in dem Speicher (31) gespeichert und auf dem Prozessor (30) lauffähig ist, aufweist, wobei der Prozessor (30) dazu ausgebildet ist, die Schritte des Verfahrens nach einem der Ansprüche 1 bis 4 zu implementieren, wenn er das Computerprogramm (32) ausführt.

7. Computerlesbares Speichermedium, in dem ein Computerprogramm (32) gespeichert ist, wobei das Computerprogramm (32) von einem Prozessor (30) ausgeführt wird, um die Schritte des Verfahrens nach einem der Ansprüche 1 bis 4 zu implementieren.

## Revendications

1. Procédé pour corriger un état de charge, SOC, d'une batterie, lequel est appliqué à une batterie qui inclut une pluralité de cellules de batterie, le procédé comprenant :
(S101) l'acquisition d'une tension mesurée de chaque cellule de batterie ; et
(S102) la détermination, conformément à la tension mesurée de chaque cellule de batterie, d'une valeur de tension maximum (Uₘₐₓ) et d'une première cellule de batterie qui correspond à la valeur de tension maximum ainsi que d'une valeur de tension minimum (Uₘᵢₙ) et d'une seconde cellule de batterie qui correspond à la valeur de tension minimum ;
**caractérisé par** :
(S103) la détermination d'une valeur de SOC cible (SOC_{target}) conformément à la valeur de tension maximum (Uₘₐₓ) et à une courbe prédéfinie de tension à courant constant, CCV, qui est stockée en tant que table en recherchant, au niveau de la courbe prédéfinie de CCV, la valeur de SOC qui correspond à la valeur de tension maximum (Uₘₐₓ) ; et
(S104) la correction d'une valeur de SOC calculée de la seconde cellule de batterie conformément à la valeur de SOC cible (SOC_{target}) et à une valeur de SOC calculée de la première cellule de batterie afin d'obtenir une valeur de SOC corrigée de la seconde cellule de batterie, dans lequel la valeur de SOC calculée de la première cellule de batterie et la valeur de SOC calculée de la seconde cellule de batterie sont acquises par l'intermédiaire d'un procédé d'intégration en termes d'ampère-heure, en acquérant une différence entre la valeur de SOC cible et la valeur de SOC calculée de la première cellule de batterie et en ajoutant la valeur de SOC calculée de la seconde cellule de batterie à la différence afin d'obtenir la valeur de SOC corrigée de la seconde cellule de batterie.

2. Procédé selon la revendication 1, comprenant en outre :
la prise en considération de la valeur de SOC cible en tant que valeur de SOC corrigée de la première cellule de batterie.

3. Procédé selon la revendication 1, dans lequel l'étape d'acquisition de la valeur de SOC calculée de la première cellule de batterie et de la valeur de SOC calculée de la seconde cellule de batterie par l'intermédiaire du procédé d'intégration en termes d'ampère-heure comprend :
la détermination de si une durée d'attente de la batterie avant un début des processus de charge et de décharge courants a atteint ou non une durée prédéfinie ;
s'il est déterminé que la durée d'attente de la batterie avant le début des processus de charge et de décharge courants est plus longue que la durée prédéfinie ou lui est égale, l'acquisition, pour chaque cellule de batterie, d'une tension en circuit ouvert de la cellule de batterie et la détermination d'une valeur de SOC initiale de la cellule de batterie conformément à la tension en circuit ouvert de la cellule de batterie ;
s'il est déterminé que la durée d'attente de la batterie avant le début des processus de charge et de décharge courants est plus courte que la durée prédéfinie, la lecture, pour chaque cellule de batterie, d'une valeur de SOC de la cellule de batterie dans un espace de stockage prédéfini lorsque l'alimentation de la batterie a été coupée la dernière fois, la valeur de SOC étant utilisée en tant que valeur de SOC initiale de la cellule de batterie ; et
le calcul d'une valeur de SOC calculée de la première cellule de batterie et d'une valeur de SOC calculée de la seconde cellule de batterie par l'intermédiaire d'un procédé d'intégration en termes d'ampère-heure conformément à la valeur de SOC initiale de la première cellule de batterie et à la valeur de SOC initiale de la seconde cellule de batterie.

4. Procédé selon la revendication 3, dans lequel l'étape de calcul de la valeur de SOC calculée de la première cellule de batterie et de la valeur de SOC calculée de la seconde cellule de batterie par l'intermédiaire du procédé d'intégration en termes d'ampère-heure conformément à la valeur de SOC initiale de la première cellule de batterie et à la valeur de SOC initiale de la seconde cellule de batterie comprend :
pour chaque cellule de batterie dans la première cellule de batterie et pour chaque cellule de batterie dans la seconde cellule de batterie, l'acquisition d'une valeur de SOC calculée de la cellule de batterie par l'intermédiaire d'une formule prédéfinie, la formule prédéfinie étant : $SOC = {SOC}_{0} - \frac{1}{{C}_{N}} {\int }_{0}^{t} Idt ;$
formule dans laquelle : *SOC* est la valeur de SOC calculée de la cellule de batterie ; *SOC₀* est une valeur de SOC initiale de la cellule de batterie ; *C_{N}* est une capacité nominale de la cellule de batterie ; et *I* est un courant de la cellule de batterie ; lorsque la cellule de batterie est dans un processus de charge, une valeur de *I* est négative ; lorsque la cellule de batterie est dans un processus de décharge, une valeur de *I* est positive ; une valeur absolue de ${\int }_{0}^{t} Idt$ représente une charge cumulée en termes d'ampère-heure de la cellule de batterie depuis un instant initial de charge jusqu'à un instant t, ou une décharge cumulée en termes d'ampère-heure de la cellule de batterie depuis un instant initial de décharge jusqu'à l'instant t.

5. Appareil (2) pour corriger un état de charge, SOC, d'une batterie, comprenant un module d'acquisition de tension (21), un premier module de détermination (22), un second module de détermination (23) et un module de correction (24), dans lequel :
le module d'acquisition de tension (21) est configuré pour acquérir une tension mesurée de chaque cellule de batterie en séquence ; et
le premier module de détermination (22) est configuré pour, conformément à la tension mesurée de chaque cellule de batterie, déterminer une valeur de tension maximum (Uₘₐₓ) et une première cellule de batterie qui correspond à la valeur de tension maximum ainsi qu'une valeur de tension minimum (Uₘᵢₙ) et une seconde cellule de batterie qui correspond à la valeur de tension minimum ;
**caractérisé en ce que** :
le second module de détermination (23) est configuré pour déterminer une valeur de SOC cible (SOC_{target}) conformément à la valeur de tension maximum (Uₘₐₓ) et à une courbe prédéfinie de tension à courant constant, CCV, qui est stockée en tant que table en recherchant, au niveau de la courbe prédéfinie de CCV, la valeur de SOC qui correspond à la valeur de tension maximum (Uₘₐₓ) ; et
le module de correction (24) est configuré pour corriger une valeur de SOC calculée de la seconde cellule de batterie conformément à la valeur de SOC cible (SOC_{target}) et à une valeur de SOC calculée de la première cellule de batterie afin d'obtenir une valeur de SOC corrigée de la seconde cellule de batterie, dans lequel la valeur de SOC calculée de la première cellule de batterie et la valeur de SOC calculée de la seconde cellule de batterie sont acquises par l'intermédiaire d'un procédé d'intégration en termes d'ampère-heure, dans lequel le module de correction (24) est configuré pour acquérir une différence entre la valeur de SOC cible (SOC_{target}) et la valeur de SOC calculée de la première cellule de batterie et pour ajouter la valeur de SOC calculée de la seconde cellule de batterie à la différence afin d'obtenir la valeur de SOC corrigée de la seconde cellule de batterie.

6. Véhicule, comprenant un appareil de commande (3), dans lequel l'appareil de commande (3) comprend une mémoire (31), un processeur (30) et un programme informatique (32) qui est stocké dans la mémoire (31) et qui peut être rendu opérationnel sur le processeur (30), le processeur (30) étant configuré pour mettre en œuvre les étapes du procédé selon l'une quelconque des revendications 1 à 4 lors de l'exécution du programme informatique (32).

7. Support de stockage lisible par ordinateur comportant, stocké en son sein, un programme informatique (32), le programme informatique (32) étant exécuté par un processeur (30) pour mettre en œuvre les étapes du procédé selon l'une quelconque des revendications 1 à 4.
